# EUROPÄISCHE PATENTSCHRIFT

(11) **EP 1 175 052 B1**
(45) Veröffentlichungstag und Bekanntmachung des Hinweises auf die Patenterteilung: **03.09.2008**
(21) Anmeldenummer: 01116106.4
(22) Anmeldetag: 03.07.2001
(51) Int. Cl.: H04L 25/05, H03K 5/13

(54) **Zwischenspeichereinrichtung**
Buffer storage arrangement
Dispositif de stockage intermédiaire

(30) Priorität: 20.07.2000 DE 10035424
(43) Veröffentlichungstag der Anmeldung: 23.01.2002
(73) Patentinhaber: Infineon Technologies AG, 81669 München (DE)
(72) Erfinder: Nygren, Aaron, 81667 München (DE)
(74) Vertreter: Müller - Hoffmann & Partner

(56) Entgegenhaltungen:
- EP-A- 0 703 663
- US-A- 4 458 165
- DATABASE WPI Section Ch, Week 199945 7. Juli 1999 (1999-07-07), Derwent Publications Ltd., London, GB; Class G06,Seite 001, AN 1999-528342 XP002348583 ARIMILLI R K; LEWIS J D; WILLIAMS D E: "Latch-and-hold circuit in master control logic of data processing system, has multiplexer activated by evaluate signal, to output multiplexed signal which is provided to latch activated by clock signal" & CN 1 221 918 A (INTERNATIONAL BUSIESS MACHINES CORP; INTERNATIONAL BUSINESS MACHINE CO) 7. Juli 1999 (1999-07-07) -& US 6 161 189 A (ARIMILLI ET AL) 12. Dezember 2000 (2000-12-12)

## Beschreibung

Die Erfindung betrifft eine Zwischenspeichereinrichtung.

Beim Austausch digitaler Daten zwischen einer sendenden Einrichtung und einer empfangenden Einrichtung wird im Übertragungskanal häufig eine Zwischenspeichereinrichtung vorgesehen. Diese Zwischenspeichereinrichtung dient dem Auffangen und Puffern der von der sendenden Einrichtung übermittelten Daten sowie der Abgabe der zwischengespeicherten Daten an die empfangende Einrichtung, und zwar in einer Art und Weise, die den unterschiedlichen Zeitstrukturen von sendender Einrichtung und empfangender Einrichtung Rechnung trägt. Somit sind bekannte Zwischenspeichereinrichtungen zwischen sendenden und empfangenden Einheiten dazu ausgebildet, eine Synchronizität zwischen dem ausgesandten und dem weitergeleiteten und dann schließlich empfangenen Datenstrom herzustellen.

Da unterschiedliche Systemanforderungen eine unterschiedlich rasche Datenabgabe an die empfangende Einheit oder Einrichtung erforderlich macht, können Zwischenspeichereinrichtungen als sogenannte FIFO-Latches (first-in-first-out) ausgelegt sein. Diese FIFO-Latches geben die empfangenen Daten in der Reihenfolge und gemäß einer vordefinierbaren Latenz, Latenzzeit oder Verzögerungszeit nach dem Empfang von der sendenden Einrichtung an die empfangende Einrichtung ab, in der sie auch emfangen werden. Dabei werden die zwischengespeicherten Daten am Ausgang jeweils solange gehalten, bis die empfangende Einheit zum Empfang bereit ist und die Daten vom Zwischenspeicher übernimmt.

Demgemäß sind derartige Zwischenspeichereinrichtungen zur Aufnahme und Zwischenspeicherung einer Eingangsleitungseinrichtung zugeführte Eingangsdaten und zur Ausgabe von mit den Eingangsdaten im wesentlichen korrespondierenden Ausgangsdaten auf eine Ausgangsleitungseinrichtung ausgebildet und können dazu in bezug auf die Latenz oder Verzögerungszeit bis zur Datenausgabe ausgewählt werden. Diese Zwischenspeichereinrichtungen können jeweils eine Mehrzahl von sogenannten Latchstufen, also Datenhaltestufen auf weisen, welche ihrerseits jeweils zumindest eine Latcheinrichtung, den eigentlichen Zwischenspeicher, sowie eine Multiplexeinrichtung umfassen. Die Multiplexeinrichtung ist dabei jeweils so in der jeweiligen Latchstufe angeordnet und ausgebildet, daß einem jeweiligen Datenausgangsanschluß der Latchstufe steuerbar wahlweise zumindest entweder in einem ersten Auswahlzustand der Multiplexeinrichtung die an der Eingangsleitungseinrichtung der Zwischenspeichereinrichtung anliegenden Eingangsdaten direkt oder in einem zweiten Auswahlzustand der Multiplexeinrichtung in der Latcheinrichtung der jeweiligen Latchstufe zwischengespeicherte Daten zuführbar sind.

Durch die steuerbare Wahl der Auswahlzustände der Multiplexeinrichtungen der Gesamtheit von Latchstufen wird somit die insgesamt nach außen hin wirksame Latenz definiert. Jede Latchstufe für sich bewirkt aufgrund der Abfolge von Latcheinrichtung und Multiplexeinrichtung eine gewisse Latenzzeit, Latenz oder Verzögerungszeit. Die Aneinanderreihung oder Anordnung in Serie der aufeinanderfolgenden Latchstufen bewirkt dann je nach Wahl der aktivierten Multiplexeinrichtungen die Auswahl einer bestimmten Latenz, so daß beim Vorliegen von n-1 in Serie geschalteten Latchstufen n verschiedene Latenzen auswählbar sind.

Bei der Zwischenspeicherung, insbesondere mit auswählbar verschiedenen Latenzen oder Verzögerungen, müssen die Ausgangsdaten auf der Ausgangsleitungseinrichtung unabhängig davon, welche Latenz ausgewählt wurde, auch dann stabil gehalten werden, wenn kein Aktivierungsbefehl oder Lesebefehl auf die Latcheinrichtungen zugreift und auch dann wenn die ausgangsseitig erste Multiplexeinrichtung, also die Latenz 1, ausgewählt wurde, bei welcher bei bekannten Zwischenspeichereinrichtungen eben keine weitere Latcheinrichtung nachfolgt, welche die anliegenden Ausgangsdaten stabil halten könnte.

Die Druckschrift US 6,161,189 A aus dem Stand der Technik bechreibt einen Latch-and-Hold-Schaltkreis, der ein Zusammenwirken mit anderen Komponenten bei unterschiedlichen Frequenzen ermöglicht. Dort wird ein Latch-and-Hold-Schaltkreis dargestellt, der einen Multiplexer und eine eigentliche Latch-Struktur aufweist. Der Multiplexer besitzt einen Dateneingangsanschluss sowie einen Rückkopplungsanschluss. Der Rückkopplungsanschluss ist mit dem Ausgangsanschluss der Latch-Einreichung verbunden. Der Multiplexer ist so ausgebildet, dass er die am Dateneingangsanschluss erscheinenden Daten als Ausgangsdaten auswählt, falls das über einen weiteren Anschluss zugeführte Auswertesignal ein aktives Signal ist, wogegen der Multiplexer die in der Rückkopplungsschleife, also die im Rückkopplungsanschluss vorliegenden Daten als Ausgabe wählt, falls das am zusätzlichen Anschluss anliegende Auswertesignal inaktiv ist.

Der Erfindung liegt die Aufgabe zugrunde, eine Zwischenspeichereinrichtung zu schaffen, bei welcher auf besonders einfache Art und Weise sichergestellt wird, daß auf der Ausgangsleitungseinrichtung anliegende Ausgangsdaten für jede ausgewählte Latenz und beiw wechsel eines Aktivierungszustandes der Latcheinrichtungen stabil gehalten werden.

Die Aufgabe wird bei einer Zwischenspeichereinrichtung der eingangs erwähnten Art erfindungsgemäß mit den Merkmalen des Anspruchs 1 gelöst. Vorteilhafte Weiterbildungen der erfindungsgemäßen Zwischenspeichereinrichtung sind Gegenstand der abhängigen Unteransprüche.

Die erfindungsgemäße Zwischenspeichereinrichtung ist auter anderem **dadurch gekennzeichnet, daß** zumindest die Multiplexeinrichtung der ausgangsseitig ersten Latchstufe im Bereich einer zur Datenzwischenspeicherung vorgesehenen Rückkoppelschleife der Latcheinrichtung dieser Latchstufe derart integriert ausgebildet ist, so daß auf der Ausgangsleitungseinrichtung ausgegebene oder anliegende Daten dort stabil, insbesondere unabhängig vom Aktivierungszustand der Latcheinrichtungen der Latchstufen und/oder von einer aktuellen Änderung der Eingangsdaten, haltbar sind.

zwan kann zur Vermeidung des Problems der Instabilität des Ausgangssignals für eine ausgewählte Latenz 1 ein zusätzlicher Latchmechanismus in der Zwischenspeichereinrichtung entweder für das Eingangssignal oder für das Ausgangssignal vorgesehen. Dies hat die Nachteile zusätzlicher Leistungsaufnahme und des Erzeugens zusätzlichenRauschens auf den Leitungen. Ferner sind die Ausgangsdaten der Ausgangsdatenleitung in einem nicht vorhersagbaren Zustand, falls für die einzelnen vorangehenden Latcheinrichtungen insgesamt kein Aktivierungssignal vorliegt. Des weiteren werden für den zusätzlichen Latchmechanismus entsprechende elektronische Bauelemente und ein Datenpfad vorgesehen, welche auf dem integrierten Baustein Platz benötigen und die Performance, insbesondere die Geschwindigkeit, der Zwischenspeichereinrichtung verschlechtern.

Eine Grundidee der vorliegenden Erfindung ist dagegen, daß eine ohnehin vorzusehende Multiplexeinrichtung, insbesondere die der ausgangsseitig ersten Latchstufe, im Bereich einer zur Datenzwischenspeicherung vorgesehenen Rückkoppelschleife der Latcheinrichtung ausgebildet ist. Dadurch wird gewährleistet, daß das Auswählen der Multiplexeinrichtung in der zur Zwischenspeicherung ohnehin vorgesehen Rückkoppelschleife erfolgt, wodurch der dort vorhandene Latchmechanismus oder die Latcheinrichtung zur Zwischenspeicherung und zur Stabilisierung mit verwendet wird. Dadurch bleibt ausgangsseitig von der ersten Latcheinrichtung das Datensignal auf der Ausgangsleitungseinrichtung stabil, und zwar unabhängig davon, ob eine Latenz ausgewählt wurde, welche Latenz ausgewählt wurde und auch unabhängig davon, ob irgendeine der Latcheinrichtungen durch einen entsprechenden Aktivierungsbefehl zum Auslesen aktiviert wurde oder nicht.

Es ist dazu in vorteilhafter Weise vorgesehen, daß jede Latchstufe für sich mindestens einen Dateneingangsanschluß und einen Datenausgangsanschluß aufweist. Die Latchstufen sind ferner so im wesentlichen in Serie angeordnet, daß von der Eingangsleitungseinrichtung zur Ausgangsleitungseinrichtung der Zwischenspeichereinrichtungen hin der Datenausgangsanschluß einer jeweiligen vorangehenden Latchstufe jeweils mit dem Dateneingangsanschluß einer direkt nachfolgenden Latchstufe verbunden ist. Durch diese Anordnung wird gerade gewährleistet, daß die Abfolge der aufeinanderfolgenden Latchstufen die Kaskadierung und Abfolge der auswählbaren Latenzen definiert.

Obwohl es grundsätzlich ausreichend ist, daß zur Stabilisierung des an der Ausgangsleitungseinrichtung anliegenden Ausgangssignals zunächst nur die Multiplexeinrichtung der ausgangsseitigen ersten Latchstufe in die Latcheinrichtung, und zwar insbesondere in eine dort vorgesehen Rückkoppelschleife zur Zwischenspeicherung ausgebildet ist, ist es aus produktionstechnischen und konzeptionellen Gründen besonders vorteilhaft, wenn sämtliche Latchstufen, insbesondere auf die Anordnung der Multiplexeinrichtungen, im wesentlichen gleich oder gleichwirkend ausgebildet sind. Diese Maßnahme sieht also vor, daß sämtliche Multiplexeinrichtungen der Latchstufen jeweils in die Latcheinrichtungen und insbesondere in einer dort jeweils vorgesehenen Rückkoppelschleife integriert angeordnet sind.

Zur Auswahl der Multiplexeinrichtung ist es besonders vorteilhaft, wenn die Multiplexeinrichtung jeweils zur Aufnahme eines Auswahlsignals, insbesondere zur Auswahl einer Latenz oder Verzögerung, ausgebildet ist. Durch dieses Auswahlsignal ist dann die jeweilige Multiplexeinrichtung zumindest in den ersten und/oder den zweiten Auswahlzustand versetzbar. Dabei bedeutet der erste Auswahlzustand zum Beispiel ein Umgehen der eigentlichen Latcheinrichtung und der darin zwischengespeicherten Daten und ein Aufnehmen und Weiterleiten der Eingangsdaten direkt aus der Eingangsleitungseinrichtung, wodurch dann die der in dieser Weise ausgewählten Multiplexeinrichtung zugeordneten Latenzzeit gesetzt wird. Der zweite Zustand der jeweiligen Multiplexeinrichtung bedeutet dann zum Beispiel entsprechend, daß die zwischengespeicherten Daten der entsprechenden zugeordneten Latcheinrichtung auf den Datenausgangsanschluß der Latchstufe zur Weiterleitung geführt werden.

In vorteilhafter Weise ist bei einer weiteren Ausführungsform der erfindungsgemäßen Zwischenspeichereinrichtung jede der Latcheinrichtungen der Latchstufen jeweils zur Aufnahme eines Lesesignals oder Aktivierungssignals ausgebildet. Durch Aufnahme des Lesesignals oder Aktivierungssignals ist die jeweilige Latcheinrichtung der Latchstufe aktivierbar, insbesondere zur Ausgabe der in ihr zwischengespeicherten Daten zum jeweiligen Ausgangsdatenanschluß der Latchstufe hin.

Zur geordneten Abfolge des Zwischenspeichervorgangs ist es in vorteilhafter Weise ferner vorgesehen, daß die Latcheinrichtung und/oder die Multiplexeinrichtung einer Latchstufe jeweils zur Aufnahme eines Taktsignals ausgebildet sind. Durch das Taktsignal, welches zur Verarbeitung der Daten zwischen sendender und empfangender Einrichtung ohnehin vorhanden ist, wird dann die Verarbeitung und insbesondere die Weiterleitung der zwischengespeicherten Daten jeweils gesteuert. Die Latenzen sind dann im wesentlichen als ganzzahlige Vielfache der Taktzeit auffaßbar.

Gemäß einer bevorzugten Ausführungsform der erfindungsgemäßen Zwischenspeichereinrichtung sind zum Zuführen des Eingangsdatensignals, des Aktivierungssignals oder Lesesignals, des Auswahlsignals und/oder des Taktsignals in jeder Latchstufe, insbesondere in jeder Latcheinrichtung, jeweils eine Leitungseinrichtung vorgesehen.

Vorteilhafterweise ist die Latcheinrichtung der Latchstufe jeweils als Flipflopeinrichtung, insbesondere als D-Flipflop, oder dergleichen ausgebildet. Grundsätzlich sind dabei sämtliche Formen und Strukturen von D-Flipflops, auf NAND- oder NOR-Gattern basierend, denkbar.

Es ist ferner von Vorteil, daß durch die Abfolge der Latcheinrichtungen und insbesondere durch die Abfolge der Flipflopeinrichtungen und/oder durch die Abfolge der Auswahlsignale die Auswahlmöglichkeiten der Latenzen oder Verzögerungszeiten definierbar ist. Beim Vorliegen von n-1 in Serie geschalteten Latchstufen ergibt sich eine Auswahl von n Latenzen. Befinden sich sämtliche Multiplexeinrichtungen im nicht aktiven, d.h. definitionsgemäß z.B. im zweiten Zustand, so werden sämtliche Latcheinrichtungen in der Latchstufe in Serie geschaltet und es ergibt sich eine maximale Latenz, welche mindestens die Summe der Einzellatenzen der einzelnen Latchstufen beträgt. Wird dagegen eine der Multiplexeinrichtungen durch ein entsprechendes Auswahlsignal aktiviert und in den ersten Zustand versetzt, bei welchem die Latcheinrichtung der zugeordneten Latchstufe und aller eingangsseitig gelegenen vorangehenden Latchstufen umgangen werden, so addieren sich ausschließlich die Latenzen der nachfolgenden, verbleibenden Latchstufen zur Gesamtlatenz. Wird ausschließlich die Multiplexeinrichtung der ausgangsseitig gelegenen ersten Latchstufe in diesen aktivierten ersten Zustand versetzt, so werden sämtliche Latchstufen umgangen und das Eingangsdatensignal erscheint im wesentlichen ohne Latenz oder Verzögerung als Ausgangsdatensignal an der Ausgangsleitungseinrichtung, wobei aber aufgrund der Integration dieser ersten Multiplexeinrichtung in einen Bereich einer zur Zwischenspeicherung vorgesehenen Rückkoppelschleife wegen der dann wirkenden Rückkopplung ein entsprechendes stabiles Halten dieser Ausgangsdatensignale auf der Ausgangsleitungseinrichtung gewährleistet ist. Eine besonders einfache Ausführungsform der erfindungsgemäßen Zwischenspeichereinrichtung ergibt sich dann, wenn durch die Auswahlsignale höchstens eine der Multiplexeinrichtungen der Latchstufen in einen zweiten Auswahlzustand, nämlich den aktivierten Zustand, überführbar ist.

Nachfolgend wird die Erfindung anhand einer schematischen Zeichnung auf der Grundlage bevorzugter Ausführungsformen der erfindungsgemäßen Zwischenspeichereinrichtung näher erläutert. In dieser zeigt:
- Fig. 1: ein schematisches Blockdiagramm einer ersten Ausführungsform der erfindungsgemäßen Zwischenspeichereinrichtung,
- Fig. 2: eine andere Ausführungsform der erfindungsgemäßen Zwischenspeichereinrichtung und
- Fig. 3: eine andere Zwischenspeichereinrichtung zum Vergleich.

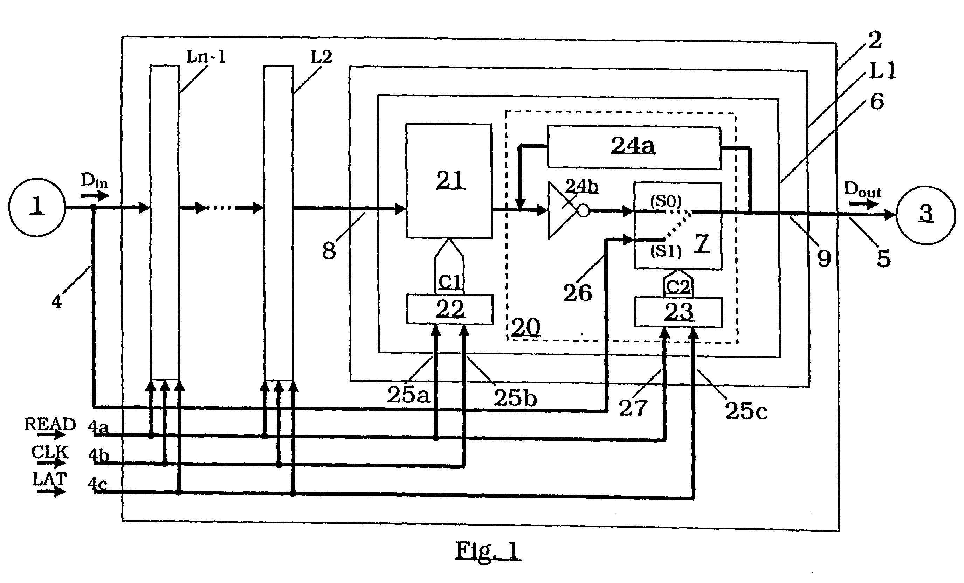

Bei der in Fig. 1 gezeigten Ausführungsform der erfindungsgemäßen Zwischenspeichereinrichtung 2 weist diese ausschließlich eine modifizierte erste Latchstufe L1 mit einer Latcheinrichtung 6 auf, in welcher in einem Bereich 20 einer zur Zwischenspeicherung vorgesehenen Rückkoppelschleife gerade die Multiplexeinrichtung 7 dieser ersten Latchstufe L1 integriert ausgebildet ist.

Von einer sendenden Einrichtung 1 ausgehend werden über eine Eingangsleitungseinrichtung 4 der Zwischenspeichereinrichtung 2 Eingangsdaten Dᵢₙ zugeführt. Diese durchlaufen gegebenenfalls vorgeschaltete Latchstufen Ln-1 bis L2, die konventionell ausgestaltet sein können. Ausgangsseitig befindet sich dann die erste Latchstufe L1, welche erfindungsgemäß weitergebildet ist, wie das oben bereits beschrieben wurde. Die Ausgangsdaten Dₒᵤₜ werden von dieser ersten Latchstufe L1 über den entsprechenden Datenausgangsanschluß 9 auf der Ausgangsleitungseinrichtung 5 der empfangenden Einrichtung 3 bereitgestellt.

Der Latcheinrichtung L1 werden über einen Dateneingangsanschluß 8 gegebenenfalls Daten der nachfolgenden Latchstufe L2 zugeführt. Die Anordnung zur Zwischenspeicherung in der Latcheinrichtung der Latchstufe L1 besteht im wesentlichen aus zwei Rückkoppelkreisen 20 und 21, wobei der erste Rückkoppelkreis 21 konventionell ausgestaltet sein kann und durch eine Logik 22 steuerbar ist, welche ein Taktsignal CLK über eine Taktleitung 25b und ein Aktivierungs-/Lesesignal READ über eine Leitung 25a erhält und diese zu einem Steuersignal C1 für den Rückkoppelkreis 21 weiterverarbeitet.

Der zweite Rückkoppelkreis 20 kann in analoger Weise wie der erste Rückkoppelkreis 21 im wesentlichen mit einem Rückkoppelglied 24a und einem Inverter 24b gebildet werden, wobei aber in den Bereich 20 der zweiten Rückkoppelschleife die Multiplexeinrichtung 7 in den Pfad eingebracht ist, und zwar derart, daß im nicht aktivierten Zustand S0 der Multiplexeinrichtung die Latcheinrichtung 6 der ersten Latchstufe L1 in konventioneller Art und Weise arbeitet. Beim Ausbilden des aktivierten Zustandes S1 der in die Latcheinrichtung 6 der ersten Latchstufe L1 eingebrachten Multiplexeinrichtung 7 wird dagegen die Latcheinrichtung 6 im wesentlichen umgangen und dem Ausgangsdatenanschluß 9 der ersten Latchstufe L1 über eine Leitung 26 das an der Zwischenspeichereinrichtung 2 anliegende Eingangsdatensignal Dᵢₙ direkt zugeführt. Gesteuert wird die Multiplexeinrichtung 7 der ersten Latchstufe L1 über eine Logik 23, welche durch Verarbeitung eines Auswahlsignals LAT über eine Leitungseinrichtung 25c und gegebenenfalls des Lese-/Aktivierungssignals READ über eine Leitung 27 ein Steuersignal C2 für die Multiplexeinrichtung 7 erzeugt.

Innerhalb der Zwischenspeichereinrichtung 2 sind Leitungseinrichtungen 4, 4a, 4b und 4c für die Eingangsdaten Dᵢₙ, das Lese-/Aktivierungssignal READ, das Taktsignal CLK bzw. das Auswahlsignal für die Latenz LAT vorgesehen.

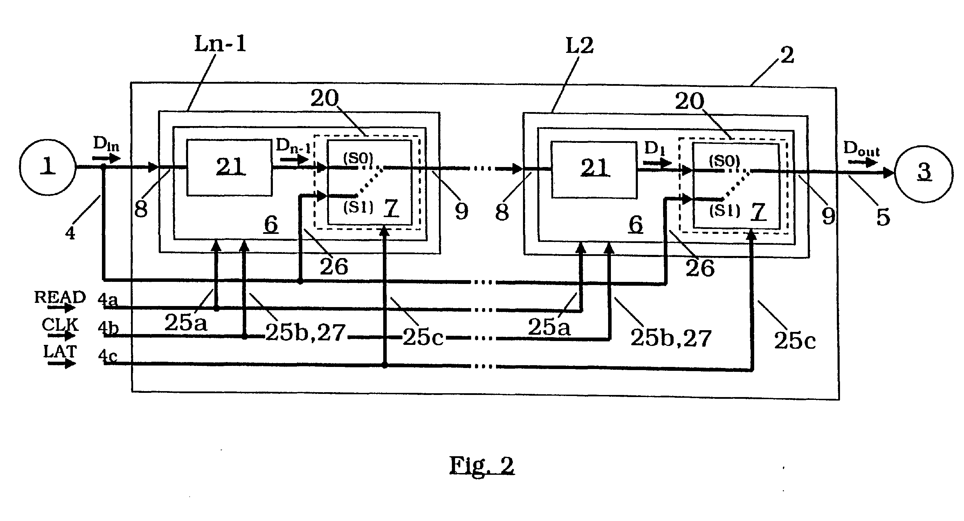

Das in der Fig. 2 gezeigte Ausführungsbeispiel der erfindungsgemäßen Zwischenspeichereinrichtung weist n-1 identische Latchstufen L1 bis Ln-1 auf, die alle die Struktur der in Fig. 1 gezeigten Latchstufe L1 besitzen und hier nur schematisch dargestellt sind. Über Leitungen 4, 4a, 4b und 4c werden die Signale Dᵢₙ, READ, CLK bzw. LAT zugeführt und über entsprechende Abgriffe 25a, 25b, 25c, 26 und 27 den jeweiligen Latcheinrichtungen 6 und den darin integrierten Multiplexeinrichtungen 7 zugeführt.

Die Multiplexeinrichtungen 7 der Latchstufen L1 bis Ln-1 der erfindungsgemäßen Ausführungsform der Fig. 2 sind jeweils in Bereichen 20 von zur Zwischenspeicherung in den Latcheinrichtungen 6 vorgesehenen Rückkoppelschleifen integriert. Diese Bereiche 20 der Rückkoppelschleifen sind in der Ausführungsform der Fig. 2 nur schematisch dargestellt.

Durch Setzen eines der Signale oder Signalkomponenten LAT1 bis LATn-1 wird höchstens eine der Multiplexeinrichtungen 7 in einen aktivierten Zustand S1 überführt, so daß die Latcheinrichtungen 6 der zugeordneten Latchstufe und aller ausgangsseitig vorangehenden Latchstufen umgangen wird, so daß an der eingangsseitig nachfolgenden Latchstufe bzw. deren Dateneingangsanschluß 8 das Eingangsdatensignal Dᵢₙ direkt anliegt. Wenn also durch ein aktivierendes Signal LATj die Multiplexeinrichtung 7 der Latcheinrichtung 6 der Latchstufe Lj in einen aktivierten Zustand S1 überführt wird, so ist mit dieser Auswahl die Latenz j-1 ausgewählt, welche sich im wesentlichen als Summe der Latenzen oder Verzögerungszeiten der von der Latchstufe Lj aus gesehen vorangehenden ausgangsseitigen Latchstufen L1 bis Lj-1 zusammensetzt.

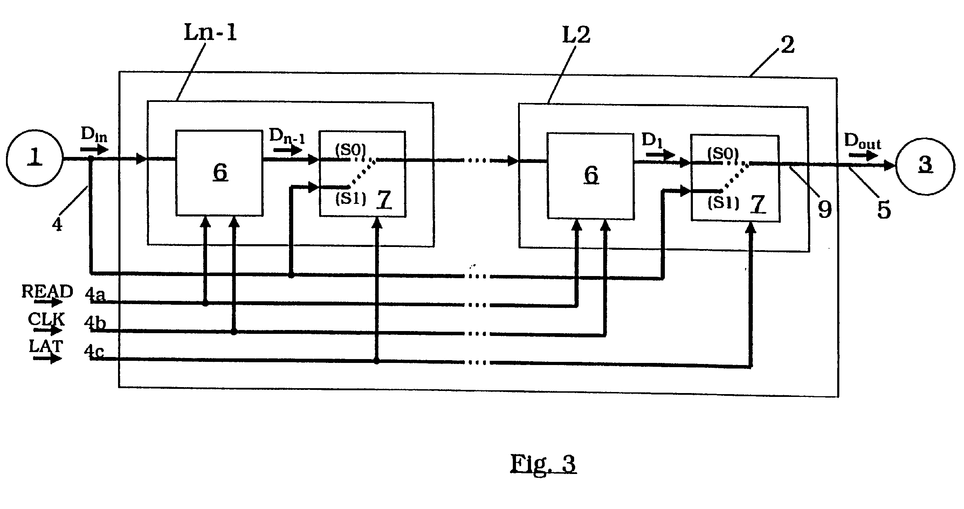

In Fig. 3 ist im Vergleich dazu eine andere Zwischenspeichereinrichtung 32 gezeigt. Diese weist ebenfalls n-1 Latchstufen L1 bis Ln-1 in Serie geschaltet auf. Sämtliche Latchstufen L1 bis Ln-1 sind identisch ausgebildet, und zwar im Gegensatz zum erfindungsgemäßen Vorgehen mit im wesentlichen in Serie geschalteter Latcheinrichtung 6 und Multiplexeinrichtung 7. Durch diese Anordnung, insbesondere im Hinblick auf die ausgangsseitig gelegene erste Latchstufe L1, ist es nicht möglich, das Ausgangsdatensignal Dₒᵤₜ auf der Ausgangsleitungseinrichtung 5 stabil zu halten, falls durch ein Aktivieren des Auswahlsignals LAT1 die Multiplexeinrichtung 7 zur Umgehung sämtlicher Latchstufen L1 bis Ln-1 bzw. deren Latcheinrichtungen 6 gesetzt ist. Dann nämlich liegt an der Ausgangsleitungseinrichtung 5 das Eingangsdatensignal Dᵢₙ direkt an, so daß eine Änderung im Eingangsdatensignal Dᵢₙ aufgrund einer fehlenden Zwischenspeicherung sich als im wesentlichen instantane entsprechende Änderung des Ausgangsdatensignals Dₒᵤₜ bemerkbar macht.

Im Gegensatz dazu wird durch das erfindungsgemäße Vorgehen, nämlich die zumindest teilweise Integration der Multiplexeinrichtung in die Latcheinrichtung der ausgangsseitig gelegenen ersten Latchstufe eine Stabilisierung der Ausgangsdaten Dₒᵤₜ gewährleistet, und zwar ohne das Ausbilden eines zusätzlichen Latchmechanismus und damit einhergehende Platzverschwendung und Verschwendung von Energieresourcen.

## Patentansprüche

1. Zwischenspeichereinrichtung (2) zur Aufnahme und Zwischenspeicherung einer Eingangsleitungseinrichtung (4) der Zwischenspeichereinrichtung (2) zugeführter Eingangsdaten (Dᵢₙ) und zur Ausgabe von mit den Eingangsdaten (Dᵢₙ) korrespondierenden Ausgangsdaten (Dₒᵤₜ) auf einer Ausgangsleitungseinrichtung (5) der Zwischenspeichereinrichtung (2) mit auswählbarer Latenz oder Verzögerung,
- mit einer Mehrzahl Latchstufen (L1, ..., Ln-1), welche jeweils zumindest eine Latcheinrichtung (6) mit einer Multiplexeinrichtung (7) aufweisen,
- wobei die Multiplexeinrichtung (7) jeweils so in der jeweiligen Latchstufe (L1, ..., Ln-1) angeordnet und ausgebildet ist, dass einem jeweiligen Datenausgangsanschluss (9) der Latchstufe (L1, ..., Ln-1) steuerbar in einem ersten Auswahlzustand (S1) der Multiplexeinrichtung (7) direkt die an der Eingangsleitungseinrichtung (4) der Zwischenspeichereinrichtung (2) anliegenden Eingangsdaten (Dᵢₙ) oder in einem zweiten Auswahlzustand (S0) der Multiplexeinrichtung (7) in der Latcheinrichtung (6) der jeweiligen Latchstufe (L1, ..., Ln-1) zwischengespeicherte Daten (D1, ..., Dn-1) zuführbar sind,
- indem die Latcheinrichtung (6) der Latchstufen (L1, ..., Ln-1) jeweils zur Aufnahme eines Lesesignals (READ) ausgebildet ist, durch welches die jeweilige Latcheinrichtung (6) aktivierbar ist zur Ausgabe der in ihr zwischengespeicherten Daten (D1, ..., Dn-1) zum Datenausgangsanschluss (9) der jeweiligen Latchstufe (L1, ..., Ln-1) hin,
- wobei die Multiplexeinrichtung (7) jeweils zur Aufnahme eines Auswahlsignals (LAT) zur Auswahl einer Latenz oder einer Verzögerungszeit ausgebildet ist, durch welches die jeweilige Multiplexeinrichtung (7) zumindest in den ersten und den zweiten Auswahlzustand (S1, S0) versetzbar ist,
- wobei zumindest die Multiplexeinrichtung (7) der ausgangsseitigen ersten Latchstufe (L1) in einer zur Datenzwischenspeicherung vorgesehenen Rückkoppelschleife der Latcheinrichtung (6) dieser ersten Latchstufe (L1) ausgebildet ist,
- wobei die weiteren Latchstufen (L2, ..., Ln-1) in Serie zueinander und vor der ersten Latchstufe (L1) angeordnet sind, und
- wobei von der Eingangsleitungseinrichtung (4) der Zwischenspeichereinrichtung (2) zur Ausgangsleitungseinrichtung (5) der Zwischenspeichereinrichtung (2) hin der jeweilige Datenausgangsanschluss (9) einer jeweiligen vorangehenden weiteren Latchstufe (Lj) jeweils mit dem Dateneingangsanschluss (8) einer direkt nachfolgenden Latchstufe (Lj-1) verbunden ist,
- so dass **dadurch** durch die Abfolge der Latcheinrichtungen (6) der Latchstufen (L1, ..., Ln-1) die Auswahlmöglichkeiten der Latenzen oder Verzögerungszeiten definiert und durch Auswahlsignale (LAT) einstellbar sind.

2. Zwischenspeichereinrichtung nach Anspruch 1,
**dadurch gekennzeichnet,**
**dass** sämtliche Latchstufen (L1, ..., Ln-1) in Bezug auf die Anordnung der jeweiligen Multiplexeinrichtung (7) in einer jeweiligen Latchstufe (L1, ..., Ln-1) gleich oder gleichwirkend ausgebildet sind.

3. Zwischenspeichereinrichtung nach einem der vorangehenden Ansprüche,
**dadurch gekennzeichnet,**
**dass** die Latcheinrichtung (6) und/oder die Multiplexeinrichtung (7) einer Latchstufe (L1, ..., Ln-1) jeweils zur Aufnahme eines Taktsignals (CLK) ausgebildet sind, durch welches die Verarbeitung jeweils steuerbar ist.

4. Zwischenspeichereinrichtung nach einem der vorangehenden Ansprüche,
**dadurch gekennzeichnet,**
**dass** zum Zuführen des Eingangsdatensignals (Dᵢₙ), eines Aktivierungssignals (READ), eines Auswahlsignals (LAT) und/oder eines Taktsignals (CLK) in jeder Latchstufe (L1, ..., Ln-1) und der jeweiligen Latcheinrichtung (6) jeweils eine Leitungseinrichtung (25, 25a, 25b, 25c) vorgesehen ist.

5. Zwischenspeichereinrichtung nach einem der vorangehenden Ansprüche,
**dadurch gekennzeichnet,**
**dass** die Latcheinrichtung (6) jeweils als D-Flipflop ausgebildet ist.

6. Zwischenspeichereinrichtung nach einem der vorangehenden Ansprüche,
**dadurch gekennzeichnet,**
**dass** durch Auswahlsignale (LAT) eine der Multiplexeinrichtungen (7) höchstens einer Latchstufe (L1, ..., Ln-1) in einen zweiten Auswahlzustand überführbar ist.

## Claims

1. Buffer device (2) for receiving and buffering input data (Dᵢₙ) fed to an input line device (4) of the buffer device (2) and for outputting output data (Dₒᵤₜ), corresponding to the input data (Dᵢₙ), on an output line device (5) of the buffer device (2) with selectable latency or delay,
- with a multiplicity of latch stages (L1, ..., Ln-1) which each have at least one latch device (6) with a multiplexer (7),
- the multiplexer (7) being arranged and embodied in each case in the respective latch stage (L1, ..., Ln-1) in such a way that a respective data output terminal (9) of the latch stage (L1, ..., Ln-1) can be supplied, in a controllable fashion, directly with the input data (Dᵢₙ) present at the input line device (4) of the buffer device (2) in a first selection state (S1) of the multiplexer (7), or with the data (D1, ..., Dn-1) buffered in the latch device (6) of the respective latch stage (L1, ..., Ln-1) in a second selection state (S0) of the multiplexer (7),
- in which the latch device (6) of the latch stages (L1, ..., Ln-1) is designed in each case to receive a read signal (READ) by means of which the respective latch device (6) can be activated to output the data (D1, ..., Dn-1) buffered in it to the data output terminal (9) of the respective latch stage (L1, ..., Ln-1),
- the multiplexer (7) being designed in each case to receive a selection signal (LAT) to select a latency or a delay time, by means of which selection signal (LAT) the respective multiplexer (7) can be transferred at least into the first and second selection states (S1, S0),
- at least the multiplexer (7) of the first latch stage (L1) on the output side being embodied in a feedback loop, provided for data buffering, of the latch device (6) of this first latch stage (L1),
- the further latch stages (L2, ..., Ln-1) being arranged in series with one another and upstream of the first latch stage (L1), and
- the respective data output terminal (9) of a respective preceding latch stage (Lj) being connected in each case to the data input terminal (8) of a directly following latch stage (Lj-1) from the input line device (4) of the buffer device (2) to the output line device (5) of the buffer device (2),
- such that the selection possibilities of the latencies or delay times are defined by the series arrangement of the latch devices (6) of the latch stages (L1, ..., Ln-1) and can be set by the selection signals (LAT).

2. Buffer device according to Claim 1, **characterized in that** all the latch stages (L1, ..., Ln-1) are of identical or identically acting design, with respect to the arrangement of each multiplexer (7), in a respective latch stage (L1, ..., Ln-1).

3. Buffer device according to one of the preceding claims, **characterized in that** the latch device (6) and/or the multiplexer (7) of a latch stage (L1, ..., Ln-1) are each designed to receive a clock signal (CLK) by means of which the processing can be respectively controlled.

4. Buffer device according to one of the preceding claims, **characterized in that** in each case a line device (25, 25a, 25b, 25c) is provided for feeding the input data signal (Dᵢₙ), an activation signal (READ), a selection signal (LAT) and/or a clock signal (CLK) in each latch stage (L1, ..., Ln-1), and of the respective latch device (6).

5. Buffer device according to one of the preceding claims, **characterized in that** the latch device (6) is embodied in each case as a D-flipflop.

6. Buffer device according to one of the preceding claims, **characterized in that** one of the multiplexers (7) of at most one latch stage (L1, ..., Ln-1) can be transferred into a second selection state by means of selection signals (LAT).

## Revendications

1. Dispositif de mémorisation temporaire ( 2 ) pour la réception et la mémorisation temporaire de données d'entrée ( Dᵢₙ ) envoyées à un dispositif de lignes d'entrée ( 4 ) du dispositif de mémorisation temporaire ( 2 ) et pour la fourniture de données de sortie ( Dₒᵤₜ ) correspondant aux données d'entrée ( Dᵢₙ ) sur un dispositif de lignes de sortie ( 5 ) du dispositif de mémorisation temporaire ( 2 ) avec une latence ou un retard sélectionnable,
- ayant plusieurs étages de verrouillage ( L1, ..., Ln-1 ) qui comportent chacun au moins un dispositif de verrouillage ( 6 ) ayant un dispositif multiplex ( 7 ),
- le dispositif multiplex ( 7 ) étant respectivement agencé et conçu de telle sorte dans l'étage de verrouillage ( L1, ..., Ln-1 ) respectif que, suivant une commande, on peut envoyer à une borne de sortie de données respective ( 9 ) de l'étage de verrouillage ( L1, ..., Ln-1 ), si le dispositif multiplex ( 7 ) est dans un premier état sélectionné ( S1 ), directement les données d'entrée ( Dᵢₙ ) présentes dans le dispositif de lignes d'entrée ( 4 ) du dispositif de mémorisation intermédiaire ( 2 ) ou, si le dispositif multiplex ( 7 ) est dans un deuxième état sélectionné ( S0 ), des données ( D1, ..., Dn-1 ) mémorisées temporairement dans le dispositif de verrouillage ( 6 ) de l'étage de verrouillage ( L1, ..., Ln-1 ) respectif,
- le dispositif de verrouillage ( 6 ) des étages de verrouillage ( L1, ..., Ln-1 ) étant conçu respectivement pour la réception d'un signal de lecture ( READ ) par lequel le dispositif de verrouillage respectif ( 6 ) est activable pour la fourniture des données ( D1, ..., Dn-1 ) mémorisées temporairement dans celui-ci à la borne de sortie de données ( 9 ) de l'étage de verrouillage respectif ( L1, ..., Ln-1 ),
- le dispositif multiplex ( 7 ) étant conçu respectivement pour la réception d'un signal de sélection ( LAT ) pour la sélection d'une latence ou d'un retard par lequel le dispositif multiplex respectif ( 7 ) peut être mis au moins dans le premier et dans le deuxième état sélectionné ( S1, S0 ),
- au moins le dispositif multiplex ( 7 ) du premier étage de verrouillage côté sortie ( L1 ) étant conçu dans une boucle de rétroaction, prévue pour la mémorisation temporaire de données, du dispositif de verrouillage ( 6 ) de ce premier étage de verrouillage ( L1 ),
- les autres étages de verrouillage ( L2, ..., Ln-1 ) étant agencés en série les uns avec les autres et avant le premier étage de verrouillage ( L1 ), et
- du dispositif de lignes d'entrée ( 4 ) du dispositif de mémorisation temporaire ( 2 ) au dispositif de lignes de sortie ( 5 ) du dispositif de mémorisation temporaire ( 2 ), la borne de sortie de données respective ( 9 ) d'un autre étage de verrouillage ( Lj ) précédent respectif étant reliée respectivement à la borne d'entrée de données ( 8 ) d'un étage de verrouillage ( Lj-1 ) directement suivant,
- de telle sorte que, grâce à la succession des dispositifs de verrouillage ( 6 ) des étages de verrouillage ( L1, ..., Ln-1 ), les possibilités de sélection des latences ou retards sont définies et réglables par des signaux de sélection ( LAT ).

2. Dispositif de mémorisation temporaire selon la revendication 1,
**caractérisé par le fait que** tous les étages de verrouillage ( L1, ..., Ln-1 ) sont conçus identiques ou avec une action identique par rapport à l'agencement du dispositif multiplex respectif ( 7 ) dans un étage de verrouillage respectif ( L1, ..., Ln-1 ).

3. Dispositif de mémorisation temporaire selon l'une des revendications précédentes,
**caractérisé par le fait que** le dispositif de verrouillage ( 6 ) et/ou le dispositif multiplex ( 7 ) d'un étage de verrouillage ( L1, ..., Ln-1 ) sont conçus à chaque fois pour la réception d'un signal d'horloge ( CLK ) par lequel le traitement est commandable.

4. Dispositif de mémorisation temporaire selon l'une des revendications précédentes,
**caractérisé par le fait que**, pour l'amenée du signal de données d'entrée ( Dᵢₙ ) d'un signal d'activation ( READ ), d'un signal de sélection ( LAT ) et/ou d'un signal d'horloge ( CLK ) dans chaque étage de verrouillage ( L1, ..., Ln-1 ) et dans le dispositif de verrouillage respectif ( 6 ), il est prévu à chaque fois un dispositif de lignes ( 25, 25a, 25b, 25c ).

5. Dispositif de mémorisation temporaire selon l'une des revendications précédentes,
**caractérisé par le fait que** le dispositif de verrouillage ( 6 ) est conçu à chaque fois comme une bascule bistable de type D.

6. Dispositif de mémorisation temporaire selon l'une des revendications précédentes,
**caractérisé par le fait que**, par des signaux de sélection ( LAT ), l'un des dispositifs multiplex ( 7 ) d'un étage de verrouillage ( L1, ..., Ln-1 ) tout au plus peut être mis dans un deuxième état sélectionné.
